# EUROPEAN PATENT SPECIFICATION

(11) **EP 2 733 886 B1**
(45) Date of publication and mention of the grant of the patent: **10.12.2014**
(21) Application number: 13005351.5
(22) Date of filing: 13.11.2013
(51) Int. Cl.: H04L 12/10, H04L 12/40, H04L 12/26, G01R 31/08

(54) **Low latency discovery for power over ethernet**
Entdeckung von Leistung über Ethernet mit geringer Verzögerung
Découverte alimentation électrique par câble Ethernet à faible retard

(30) Priority: 15.11.2012 US 201261727040 P; 07.11.2013 US 201314074278
(43) Date of publication of application: 21.05.2014
(73) Proprietor: Broadcom Corporation, Irvine, CA 92617 (US)
(72) Inventor: Diab, Wael, San Francisco, CA 94109-0720 (US); Panguluri, Sesha, Cupertino, CA 95014 (US)
(74) Representative: Jehle, Volker Armin

(56) References cited:
- EP-A2- 1 956 494
- US-A1- 2011 258 464
- US-B1- 7 358 745

## Description

### CROSS REFERENCE TO RELATED APPLICATIONS

This application claims the benefit of U.S. Provisional Patent Application Number 61/727,040, filed on November 15, 2012.

### FIELD OF THE INVENTION

This invention relates to power over Ethernet (PoE) and more specifically to PoE discovery.

### BACKGROUND

Ethernet communications provide high speed data communications over a communications link between two communications nodes that operate according the IEEE 802.3 Ethernet Standard. The communication medium between the two nodes can be twisted pair wires for Ethernet or another type of communications medium. Power over Ethernet (PoE) communication systems provide power and data communications over a communications link. More specifically, a power source device (PSE) connected to a physical layer of a first node of the communications link provides DC power (for example, 48 volts DC) to a powered device (PD) at a second node of the communications link. The DC power is transmitted simultaneously over the same communications medium with high speed data between the first node and the second node.

The PSE typically includes a controller that controls the DC power provided to the PD at the second node of the communications link. The PSE controller measures voltage, current, and temperature of outgoing and incoming DC supply lines to characterize power requirements of the PD. In addition, the PSE controller may detect and validate a compatible PD, determine a power classification signature for the validated PD, supply power to the PD, monitor the power, and reduce or remove the power from the PD when the power is no longer requested or required. During detection, if the PSE finds the PD to be non-compatible, the PSE can prevent the application of power to protect the PD from possible damage.

PoE discovery is useful to avoid powering up a system if an open or short condition is detected. However, current PoE discovery, detection, and classification systems involve fairly lengthy processes to start up. Some industries, such as the automotive industry, require much quicker start up times for data links.

United States Patent US 7358745 B1 relates to a physical layer device comprising a first transceiver that selectively communicates with a cable medium. A detector detects a power over Ethernet (POE) device. A switching device selectively provides power from a power supply over the cable medium when the detector detects the POE device. A cable tester communicates with the first transceiver, tests the cable medium and determines a cable status, and delays testing of the cable medium when the detector detects the POE device until the switching device provides the power.

United States Patent Application US 2011/0258464 A1 relates to a circuit and method for detecting a legacy powered device in a power over Ethernet system. A power source equipment (PSE) device includes a network port configurable to couple to a network cable and a detection circuit couple to the network port. The detection circuit is configured to apply a powered device (PD) detection voltage signal including first and second voltages to the network port and to sample a line current of the network port in response to the first and second voltages to detect a complex impedance indicating that a legacy PD is coupled to the network port.

### BRIEF SUMMARY OF THE INVENTION

According to an aspect, a system is provided, comprising:
a port; and
a power source equipment (PSE) controller coupled to the port, wherein the PSE controller is configured to:
   determine whether an open circuit exists at the port;
   determine whether a short circuit exists at the port; and
   determine that the system can be safely powered up if no open circuit or short circuit exists at the port.

Advantageously, the PSE controller is further configured to:
determine, using stored information, that a load coupled to the port can be approximated as a resistor.

Advantageously, the system further comprises:
a powered device (PD) coupled to the port, wherein the PSE controller is further configured to initiate a power up of the PD if no open circuit or short circuit exists at the port.

Advantageously, the PSE controller is further configured to:
measure a port voltage at the port;
determine whether the port voltage is greater than a predetermined open circuit voltage; and
determine that the open circuit exists if the port voltage is greater than the predetermined open circuit voltage.

Advantageously, the PSE controller is further configured to:
determine whether a discovery timer is greater than a predetermined open circuit time; and
determine that the open circuit exists if:
   the discovery timer is greater than the predetermined open circuit time, and
   the port voltage is greater than the predetermined open circuit voltage.

Advantageously, the PSE controller is further configured to:
measure a port voltage at the port;
determine whether the port voltage is greater than a predetermined short circuit voltage; and
determine that the short circuit exists if the port voltage is less than the predetermined short circuit voltage.

Advantageously, the PSE controller is further configured to:
determine whether a discovery timer is greater than a predetermined short circuit time; and determine that the short circuit exists if:

the discovery timer is greater than the predetermined open circuit time, and
the port voltage is less than the predetermined short circuit voltage.

According to an aspect, a method is provided for reduced latency discovery in a power over Ethernet (PoE) system, the method comprising:
determining whether an open circuit exists at a port in the PoE system;
determining whether a short circuit exists at the port; and
determining that the PoE system can be safely powered up if no open circuit or short circuit exists at the port.

Advantageously, the method further comprises
determining, using stored information, that a load coupled to the port can be approximated as a resistor.

Advantageously, the method further comprises:
initiating a power up of a powered device (PD) if no open circuit or short circuit exists at the port.

Advantageously, the method further comprises:
applying a current to the port; and
starting a discovery timer while applying the current.

Advantageously, the method further comprises:
measuring a port voltage at the port;
determining whether the port voltage is greater than a predetermined open circuit voltage; and
determining that the open circuit exists if the port voltage is greater than the predetermined open circuit voltage.

Advantageously, the method further comprises:
determining whether the discovery timer is greater than a predetermined open circuit time; and
determining that the open circuit exists if:
   the discovery timer is greater than the predetermined open circuit time, and
   the port voltage is greater than the predetermined open circuit voltage.

Advantageously, the method further comprises:
measuring a port voltage at the port;
determining whether the port voltage is greater than a predetermined short circuit voltage; and
determining that the short circuit exists if the port voltage is less than the predetermined short circuit voltage.

Advantageously, the method further comprises:
determining whether the discovery timer is greater than a predetermined short circuit time; and
determining that the short circuit exists if:
   the discovery timer is greater than the predetermined open circuit time, and
   the port voltage is less than the predetermined short circuit voltage.

According to an aspect, a power over Ethernet (PoE) system comprises:
a port; and
a power source equipment (PSE) controller coupled to the port, wherein the PSE controller is configured to:
   apply a current to the port;
   measure a port voltage at the port;
   determine whether the port voltage is greater than a predetermined open circuit voltage;
   determine whether the port voltage is greater than a predetermined short circuit voltage; and
   determine that the system can be safely powered up if the port voltage is less than the predetermined open circuit voltage and the port voltage is greater than the predetermined short circuit voltage.

Advantageously, the PSE controller is further configured to:
determine, using stored information, that a load coupled to the port can be approximated as a resistor.

Advantageously, the PoE system further comprises:
a powered device (PD) coupled to the port, wherein the PSE controller is further configured to initiate a power up of the PD if no open circuit or short circuit exists at the port.

Advantageously, the PSE controller is further configured to:
determine that an open circuit exists if:
   a discovery timer is greater than a predetermined open circuit time, and
   the port voltage is greater than the predetermined open circuit voltage; and determine that a short circuit exists if:
      the discovery timer is greater than the predetermined open circuit time, and
      the port voltage is less than the predetermined short circuit voltage.

Advantageously, the PoE system further comprises:
a memory configured to store the predetermined short circuit voltage, the predetermined short circuit time, the predetermined open circuit voltage, and the predetermined open circuit time.

### BRIEF DESCRIPTION OF THE DRAWINGS/FlGURES

The accompanying drawings, which are incorporated in and constitute part of the specification, illustrate embodiments of the disclosure and, together with the general description given above and the detailed descriptions of embodiments given below, serve to explain the principles of the present disclosure. In the drawings:
FIG. 1 is a block diagram of a conventional Power over Ethernet (PoE) system.
FIG. 2 is a diagram illustrating power transfer from the Power Source Equipment (PSE) to the Powered Device (PD) in a PoE communications system in accordance with an embodiment of the present disclosure.
FIG. 3A is a circuit diagram of a PoE system configured to initiate a discovery of a load in accordance with an embodiment of the present disclosure.
FIG. 3B is a block diagram of an exemplary PSE Controller in accordance with an embodiment of the present disclosure.
FIG. 4A is a circuit diagram illustrating an open circuit condition detected by a PSE controller during discovery in accordance with an embodiment of the present disclosure.
FIG. 4B is a circuit diagram illustrating a short circuit condition detected by a PSE controller during discovery in accordance with an embodiment of the present disclosure.
FIG. 5 illustrates a method for open circuit detection in accordance with an embodiment of the present disclosure.
FIG. 6 illustrates a method for short circuit detection in accordance with an embodiment of the present disclosure.
FIG. 7 illustrates a method for combined open circuit and short circuit detection in accordance with an embodiment of the present disclosure.

Features and advantages of the present disclosure will become more apparent from the detailed description set forth below when taken in conjunction with the drawings, in which like reference characters identify corresponding elements throughout. In the drawings, like reference numbers generally indicate identical, functionally similar, and/or structurally similar elements. The drawing in which an element first appears is indicated by the leftmost digit(s) in the corresponding reference number.

### DETAILED DESCRIPTION

In the following description, numerous specific details are set forth to provide a thorough understanding of the disclosure. However, it will be apparent to those skilled in the art that the disclosure, including structures, systems, and methods, may be practiced without these specific details. The description and representation herein are the common means used by those experienced or skilled in the art to most effectively convey the substance of their work to others skilled in the art. In other instances, well-known methods, procedures, components, and circuitry have not been described in detail to avoid unnecessarily obscuring aspects of the disclosure.

References in the specification to "one embodiment," "an embodiment," "an example embodiment," etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described.

Embodiments of the disclosure can be implemented in hardware, firmware, software, or any combination thereof. Embodiments of the disclosure can also be implemented as instructions stored on a machine-readable medium, which can be read and executed by one or more processors. A machine-readable medium can include any mechanism for storing or transmitting information in a form readable by a machine (e.g., a computing device). For example, a machine-readable medium can include non-transitory machine-readable mediums such as read only memory (ROM); random access memory (RAM); magnetic disk storage media; optical storage media; flash memory devices; and others. As another example, the machine-readable medium can include transitory machine-readable medium such as electrical, optical, acoustical, or other forms of propagated signals (e.g., carrier waves, infrared signals, digital signals, etc.). Further, firmware, software, routines, instructions can be described herein as performing certain actions. However, it should be appreciated that such descriptions are merely for convenience and that such actions in fact result from computing devices, processors, controllers, or other devices executing the firmware, software, routines, instructions, etc.

The following Detailed Description of the exemplary embodiments will so fully reveal the general nature of the disclosure that others can, by applying knowledge of those skilled in relevant art(s), readily modify and/or adapt for various applications such exemplary embodiments, without undue experimentation, without departing from the spirit and scope of the disclosure. Therefore, such adaptations and modifications are intended to be within the meaning and plurality of equivalents of the exemplary embodiments based upon the teaching and guidance presented herein. It is to be understood that the phraseology or terminology herein is for the purpose of description and not of limitation, such that the terminology or phraseology of the present specification is to be interpreted by those skilled in relevant art(s) in light of the teachings herein.

For purposes of this discussion, the term "module" shall be understood to include at least one of software, firmware, and hardware (such as one or more circuits, microchips, or devices, or any combination thereof), and any combination thereof. In addition, it will be understood that each module can include one, or more than one, component within an actual device, and each component that forms a part of the described module can function either cooperatively or independently of any other component forming a part of the module. Conversely, multiple modules described herein can represent a single component within an actual device. Further, components within a module can be in a single device or distributed among multiple devices in a wired or wireless manner.

### 1. Overview

Embodiments of the present disclosure provide solutions to reduce time required for discovery in a Power over Ethernet (PoE) system. In certain applications (e.g., automotive and other industrial applications), the nature of a load of a Powered Device (PD) is known by a Power Source Equipment (PSE) controller before discovery begins. In such a case, fewer measurements need to be performed before the PoE system can be safely powered up, namely before the PSE provides power to the PD. Instead of performing several measurements for different voltage levels to characterize the load, the PSE controller can save discovery time by checking to see if an open circuit or short circuit condition exists before powering up the system.

### 2. PoE Systems

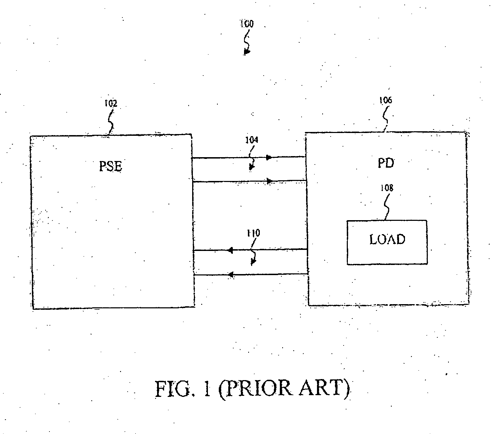

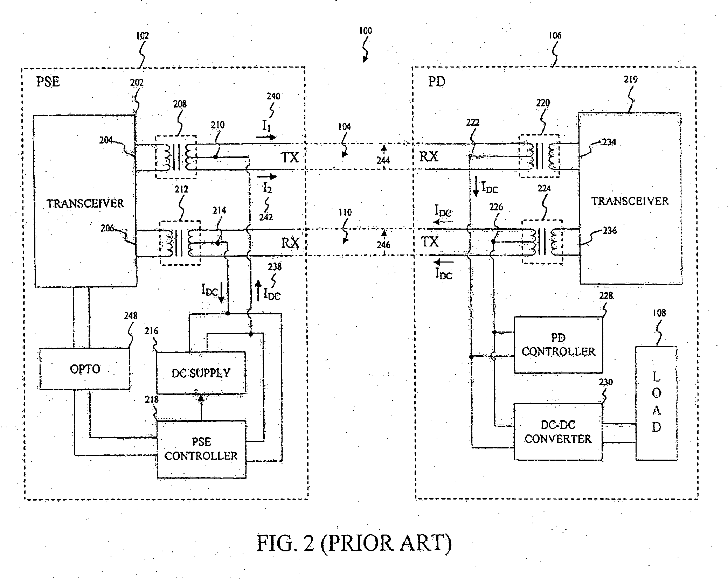

Conventional PoE systems will now be described with reference to FIGS. 1 and 2. FIG. 1 illustrates a high level diagram of a conventional Power over Ethernet (PoE) system 100 that provides both DC power and data communication over a common data communication medium. Referring to FIG. 1, Power Source Equipment (PSE) 102 provides DC power over conductors 104, 110 to a Powered Device (PD) 106 having a representative electrical load 108. The PSE 102 and PD 106 also include data transceivers that operate according to a known communication standard, such as the IEEE Ethernet standard. More specifically, the PSE 102 includes a physical layer device on the PSE side that transmits and receives high speed data with a corresponding physical layer device in the PD 106, as will be discussed further below. Accordingly, the power transfer between the PSE 102 and the PD 106 occurs simultaneously with the exchange of high speed data over the conductors 104, 110. In one example, the PSE 102 is a data switch having multiple ports that is communication with one or more PDs 106, such as, one or more Internet phones, or one or more wireless access points.

The conductor pairs 104 and 110 can carry high speed differential data communication. In one example, the conductor pairs 104 and 110 each include one or more twisted wire pairs, or any other type of cable or communication media capable of carrying the data transmissions and DC power transmissions between the PSE 102 and PD 106. In Ethernet communication, the conductor pairs 104 and 110 can include multiple twisted pairs, for example four twisted pairs for 10 Gigabit Ethernet. In 10/100 Ethernet, only two of the four pairs carry data communication, and the other two pairs of conductors are unused. Herein, conductor pairs may be referred to as Ethernet cables or communication links for ease of discussion.

FIG. 2 is a diagram illustrating power transfer from the Power Source Equipment (PSE) to the Powered Device (PD) in a PoE communications system in accordance with an embodiment of the present disclosure. FIG. 2 provides a more detailed circuit diagram of the PoE system 100, where PSE 102 provides DC power to PD 106 over conductor pairs 104 and 110. PSE 102 includes a transceiver physical layer device (or PHY) 202 having full duplex transmit and receive capability through differential transmit port 204 and differential receive port 206. (Herein, transceivers may be referred to as PHYs). A first transformer 208 couples high speed data between the transmit port 204 and the first conductor pair 104. Likewise, a second transformer 212 couples high speed data between the receive port 206 and the second conductor pair 110. The respective transformers 208 and 212 pass the high speed data to and from the transceiver PHY 202, but isolate any low frequency or DC voltage from the transceiver ports, which may be sensitive large voltage values.

The first transformer 208 includes primary and secondary windings, where the secondary winding includes a center tap 210. Likewise, the second transformer 212 includes primary and secondary windings, where the secondary winding includes a center tap 214. The DC voltage supply 216 generates an output voltage that is applied across the respective center taps of the transformers 208 and 210 on the conductor side of the transformers. The center tap 210 is connected to a first output of a DC voltage supply 216, and the center tap 214 is connected to a second output of the DC voltage supply 216. As such, the transformers 208 and 212 isolate the DC voltage from the DC supply 216 from the sensitive data ports 204, 206 of the transceiver PHY 202. An example DC output voltage is 48 volts, but other voltages could be used depending on the voltage/power requirements of the PD 106.

The PSE 102 further includes a PSE controller 218 that controls the DC voltage supply 216 based on the dynamic needs of the PD 106. More specifically, the PSE controller 218 measures voltage, current, and temperature of the outgoing and incoming DC supply lines so as to characterize the power requirements of the PD 106.

Further, the PSE controller 218 detects and validates a compatible PD, determines a power classification signature for the validated PD, supplies power to the PD, monitors the power, and reduces or removes the power from the PD when the power is no longer requested or required. During detection, if the PSE finds the PD to be non-compatible, the PSE can prevent the application of power to that PD device, protecting the PD from possible damage. IEEE has imposed standards on the detection, power classification, and monitoring of a PD by a PSE in the IEEE 802.3af^{™} standard, which is incorporated herein by reference.

Still referring to FIG. 2, the contents and functionality of the PD 106 will now be discussed. The PD 106 includes a transceiver physical layer device (or PHY) 219 having full duplex transmit and receive capability through differential transmit port 236 and differential receive port 234. A third transformer 220 couples high speed data between the first conductor pair 104 and the receive port 234. Likewise, a fourth transformer 224 couples high speed data between the transmit port 236 and the second conductor pair 110. The respective transformers 220 and 224 pass the high speed data to and from the transceiver PHY 219, but isolate any low frequency or DC voltage from the sensitive transceiver data ports.

The third transformer 220 includes primary and secondary windings, where the secondary winding (on the conductor side) includes a center tap 222. Likewise, the fourth transformer 224 includes primary and secondary windings, where the secondary winding (on the conductor side) includes a center tap 226. The center taps 222 and 226 supply the DC power carried over conductors 104 and 110 to the representative load 108 of the PD 106, where the load 108 represents the dynamic power draw needed to operate PD 106. A DC-DC converter 230 may be optionally inserted before the load 108 to step down the voltage as necessary to meet the voltage requirements of the PD 106. Further, multiple DC-DC converters 230 may be arrayed in parallel to output multiple different voltages (3 volts, 5 volts, 12 volts) to supply different loads 108 of the PD 106.

The PD 106 further includes a PD controller 228 that monitors the voltage and current on the PD side of the PoE configuration. The PD controller 228 further provides the necessary impedance signatures on the return conductor 110 during initialization, so that the PSE controller 218 will recognize the PD as a valid PoE device, and be able to classify its power requirements.

During ideal operation, a direct current (I_{DC}) 238 flows from the DC power supply 216 through the first center tap 210, and divides into a first current (I₁) 240 and a second current (I₂) 242 that is carried over conductor pair 104. The first current (I₁) 240 and the second current (I₂) 242 then recombine at the third center tap 222 to reform the direct current (I_{DC}) 238 so as to power PD 106. On return, the direct current (I_{DC}) 238 flows from PD 106 through the fourth center tap 226, and divides for transport over conductor pair 110. The return DC current recombines at the second center tap 214, and returns to the DC power supply 216. As discussed above, data transmission between the PSE 102 and the PD 106 occurs simultaneously with the DC power supply described above. Accordingly, a first communication signal 244 and/or a second communication signal 246 are simultaneously differentially carried via the conductor pairs 104 and 110 between the PSE 102 and the PD 106. It is important to note that the communication signals 244 and 246 are differential signals that ideally are not affected by the DC power transfer.

### 3. Low Latency Discovery PoE Systems

Many PoE systems use one or more discovery processes that involve lengthy discovery processes. Many industrial applications, such as Reduced Twisted pair Gigabit Ethernet (RTPGE) applications and automotive applications, require quick startup times for data links. Embodiments of the present disclosure provide solutions to reduce the time required for discovery.

For example, referring to FIG. 2, PSE controller 218 can initiate a discovery across a line (e.g., lines 104 and 110) coupled to a load (e.g., load 108) to characterize load 108 (e.g., to discover its resistance and/or capacitance). To do so, PSE controller 218 can initiate a voltage on the conductor pairs 104 and 110, gradually step the voltage up, and take measurements (e.g., current measurements) over the conductor pairs 104 and 110 to discover a response on the conductor pairs 104 and 110 to the voltage increase. Based on the nature of this response, PSE controller 218 can characterize the nature of load 108. This voltage builds up a charge across circuit elements, such as resistors, and this charge should ideally be depleted (i.e., "bled out") before another phase of the discovery is initiated so that "clean" readings can be taken.

If the nature of the load is unknown, discovery time can be further increased For example, some load elements (e.g., elements storing a charge like parasitic capacitors) may take longer to characterize. As the voltage is stepped up, and as more current measurements are taken, these load elements can have a different response than elements behaving more like resistors. For example, any voltage built up across these load elements can take longer to deplete than elements behaving more like resistors.

In some industrial control applications (e.g., automotive applications), the nature of the load is known to approximate a resistor, and it is therefore unnecessary to re-characterize the nature of the load (e.g., load 108) by taking multiple current measurements as the voltage is stepped up. In these industrial control applications, because the nature of the load is already known, there is no need to take multiple current measurements to characterize load. Rather, only the signal pathways between the PSE and the load need to be fault tested, for example, detecting an open circuit in the signal pathway between the PSE and the load or a short circuit in the signal pathway between the PSE and the load which can result from some type of fault. When a short circuit is detected, a voltage should not be applied to avoid an unwanted current spike. When an open circuit is detected, a voltage should not be applied because there may be a problem with the signal pathway between the PSE and the load. Embodiments of the present disclosure provide systems and methods to speed up discovery when the nature of the load is known by testing for open circuit and short circuit conditions.

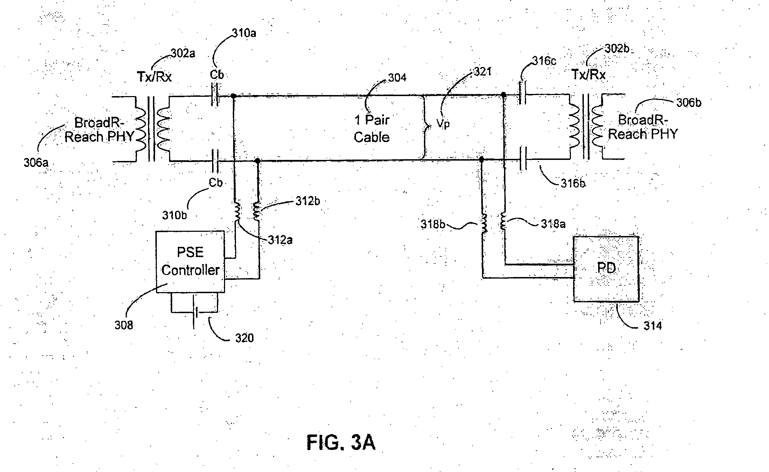

FIG. 3A is a circuit diagram of a PoE system configured to initiate a discovery of a load in accordance with an embodiment of the present disclosure. In FIG. 3A, two transformers 302 are coupled to respective physical layers 306. Transformers 302 are coupled to each other across a wired communication link 304. PSE controller 308 and PD 314 are coupled to wired communication link 304. Blocking capacitors 310 and 316 are positioned between transformers 302 and the couplings of PSE controller 308 and PD 314 to wired communication link 304. Inductors 312 and 318 are coupled between PSE controller 308 and PD 314 and wired communication link 304. In an embodiment, PSE controller 308 is coupled to a current source 320 and uses current source 320 to apply currents to perform tests during discovery. In another embodiment, current source 320 is located within PSE controller 308.

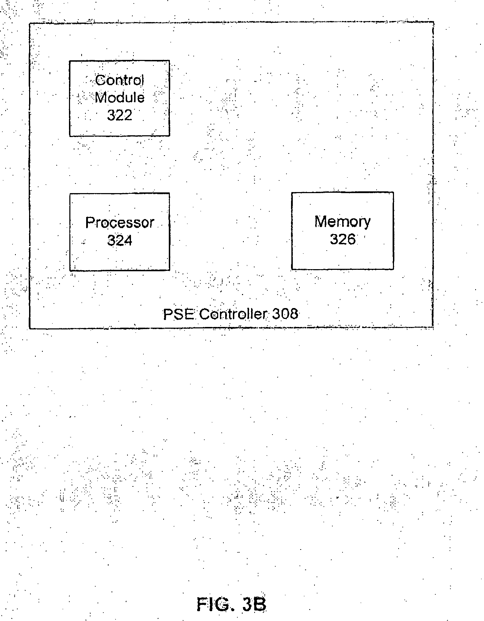

FIG. 3B is a block diagram illustrating exemplary components of PSE controller 308. In an embodiment, PSE controller 3B contains a processor 324, a memory 326, and a control module 322. In another embodiment, PSE controller 308 does not contain processor 324 or memory 326 but rather has access to a processor and a memory located outside of PSE controller 308.

In an embodiment, control module 322 performs one or more discovery operations in accordance with embodiments of the present disclosure, including open circuit detection and/or short circuit detection. Exemplary operation of the control module 322 in performing the open circuit detection and/or short circuit detection will be discussed in further detail below. Control module 322 can be implemented using hardware, software, or both hardware and software in accordance with embodiments of the present disclosure. For example, in an embodiment, control module 322 can be implemented using a single integrated circuit (IC) or using multiple ICs.

By using prior knowledge of the nature of the load (e.g., by knowing that the load can be approximated as a resistor using stored information accessible by PSE controller 308), PSE controller 308 can simplify the discovery process by checking for open circuit and short circuit conditions and avoiding the need to take multiple measurements to characterize the load.

### 3.1 Open Circuit Detection

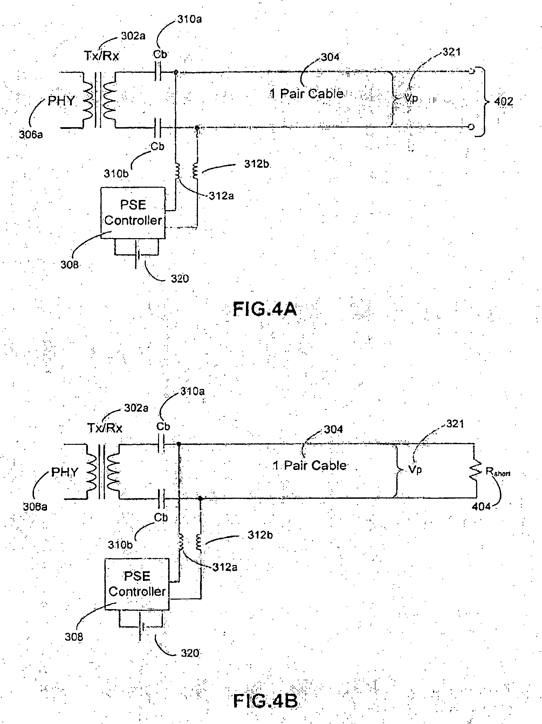

FIGS. 4A and 4B are circuit diagrams illustrating short circuit and open circuit conditions that can be detected by PSE controller 308 during discovery in accordance with an embodiment of the present disclosure. FIG. 4A illustrates open circuit detection by PSE controller 308 during discovery. For example, a certain voltage threshold V_{OC} can be defined as an open circuit voltage threshold, which is the minimum port voltage that can be reached with a current source in the case of an open circuit condition. In an embodiment, threshold V_{OC} is a predetermined quantity known by PSE controller 308 (e.g., stored in memory 326). Thus, if PSE controller 308 determines that the port voltage Vₚ 321 is higher than this voltage threshold V_{OC,} then PSE controller 308 can determine that an open circuit condition exists and can avoid powering up any PD's (e.g., PD 314) coupled to the open circuit. When PSE controller 308 detects an open circuit, PSE controller 308 can either terminate discovery, proceed to discover other PD's, or restart the discovery process for the same PD.

In some cases, a certain amount of time T_{oc} can be required for PSE controller 308 to accurately determine that an open circuit exists. For example, PSE controller 308 may want to wait a predetermined amount of time after applying a current to allow the voltage to stabilize and to get an accurate voltage reading before declaring that an open circuit exists. In an embodiment, T_{oc} is a predetermined quantity known by PSE controller 308 (e.g., stored in memory 326). Thus, to determine if an open circuit exists, PSE controller 308 can apply a current, wait until T_{oc}, measure port voltage Vₚ 321, and determine if Vₚ 321 is higher than the open circuit voltage threshold V_{OC}. If time T_{oc} has elapsed and Vₚ 321 is greater than (or, in an embodiment, greater than or equal to) V_{OC}, PSE controller 308 can determine that an open circuit condition exists. If time T_{OC} has elapsed and Vₚ 321 is less than (or, in an embodiment, greater than or equal to) V_{OC}, PSE controller 308 can determine that an open circuit condition does not exist. In an embodiment, control module 322 of PSE controller 308 can track one or more timers used during discovery. For example, control module 322 can start a timer T_{d} when discovery begins and can determine when T_{d} reaches T_{OC}.

An example of open circuit detection by PSE controller 308 will now be discussed with reference to FIG. 4A. When PSE controller 308 starts discovery, PSE controller 308 can use a current source (e.g., current source 320) to apply a current over wired communication link 304. When PSE controller 308 applies this current, PSE controller 308 also starts a timer T_{d} to keep track of the elapsed time during discovery. In an embodiment, PSE controller 308 can continually measure Vₚ 321 during the discovery process. In another embodiment, PSE controller 308 can wait until T_{OC} to measure Vₚ. When T_{d} reaches T_{oc}, PSE controller 308 can determine whether Vₚ is greater than (or, in an embodiment, greater than or equal to) V_{OC}. If Vₚ 321 is greater than (or, in an embodiment, greater than or equal to) V_{OC}, PSE controller 308 can determine that an open circuit condition exists. If time T_{OC} has elapsed and Vₚ 321 is less than (or, in an embodiment, less than or equal to) V_{OC,} PSE controller 308 can determine that an open circuit condition does not exist. If PSE controller 308 determines that an open circuit condition does not exist, PSE controller 308 can proceed with discovery of PD 314 and can power up PD 314 once discovered. If PSE controller 308 determines that an open circuit condition does exist, PSE controller 308 can either terminate discovery, proceed to discover other PD's, or restart the discovery process for the same PD.

In an embodiment, when PSE 308 determines that an open circuit exists, PSE 308 can turn on a bleeding resistor to discharge any electric charge that can build up in the open circuit. PSE 308 can leave the bleeding resistor on for sufficient time to discharge the electric charge and can then turn the bleeding resistor back off.

### 3.2 Short Circuit Detection

FIG. 4B illustrates short circuit detection by PSE controller 308 during discovery. In an embodiment, another voltage threshold Vₛₕₒᵣₜ can be defined as the maximum port voltage that can be reached with a current source in the case of a short circuit condition. If the port voltage Vₚ 321 is less than (or, in an embodiment, less than or equal to) Vₛₕₒᵣₜ, then PSE controller 308 can determine that a short circuit condition exists. When PSE controller 308 detects a short circuit, PSE controller 308 can either terminate discovery, proceed to discover other PD's, or restart the discovery process for the same PD.

In an embodiment, threshold Vₛₕₒᵣₜ is a predetermined quantity known by PSE controller 308 (e.g., stored in memory 326). Additionally, in an embodiment, PSE controller 308 waits for another predetermined amount of time Tₛₕₒᵣₜ to elapse before determining that a short circuit exists. In an embodiment, time Tₛₕₒᵣₜ is a predetermined quantity known by PSE controller 308 (e.g., stored in memory 326). Thus, to determine if a short circuit exists, PSE controller 308 can apply a current, wait for time Tₛₕₒᵣₜ, measure port voltage Vₚ 321, and determine if Vₚ 321 is less than (or, in an embodiment, less than or equal to) the short circuit voltage threshold Vₛₕₒᵣₜ. If time Tₛₕₒᵣₜ has elapsed and Vₚ 321 is greater than (or, in an embodiment, greater than or equal to) Vₛₕₒᵣₜ, PSE controller 308 can determine that a short circuit condition does not exist. If time Tₛₕₒᵣₜ has elapsed and Vₚ 321 is less than (or, in an embodiment, less than or equal to) Vₛₕₒᵣₜ, PSE controller 308 can determine that a short circuit condition exists. In an embodiment, PSE controller 308 can track Tₛₕₒᵣₜ. For example, PSE 308 can start a timer T_{d} when discovery begins and can determine when T_{d} reaches Tₛₕₒᵣₜ.

An example of short circuit detection by PSE controller 308 will now be discussed with reference to FIG. 4B. When PSE controller 308 starts discovery, PSE controller 308 can use a current source (e.g., current source 320) to apply a current over wired communication link 304. When PSE controller 308 applies this current, PSE controller 308 also starts a timer T_{d} to keep track of the elapsed time during discovery. In an embodiment, PSE controller 308 can continually measure Vₚ 321 during the discovery process. In another embodiment, PSE controller 308 can wait until Tₛₕₒᵣₜ to measure Vₚ. When T_{d} reaches Tₛₕₒᵣₜ, PSE controller 308 can determine whether Vₚ is less than (or, in an embodiment, less than or equal to) Vₛₕₒᵣₜ. If time Tₛₕₒᵣₜ has elapsed and Vₚ 321 is less than (or, in an embodiment, less than or equal to) Vₛₕₒᵣₜ, PSE controller 308 can determine that a short circuit condition exists. If time Tₛₕₒᵣₜ has elapsed and Vₚ 321 is greater than (or, in an embodiment, greater than or equal to) Vₛₕₒᵣₜ, PSE controller 308 can determine that a short circuit condition does not exist. If PSE controller 308 determines that a short circuit condition does not exist, PSE controller 308 can proceed with discovery of PD 314 and can power up PD 314 once discovered. If PSE controller 308 determines that a short circuit condition does exist, PSE controller 308 can either terminate discovery, proceed to discover other PD's, or restart the discovery process for the same PD.

### 4. Methods

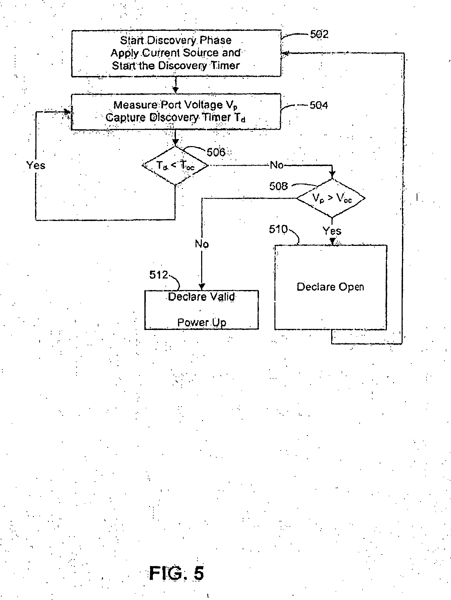

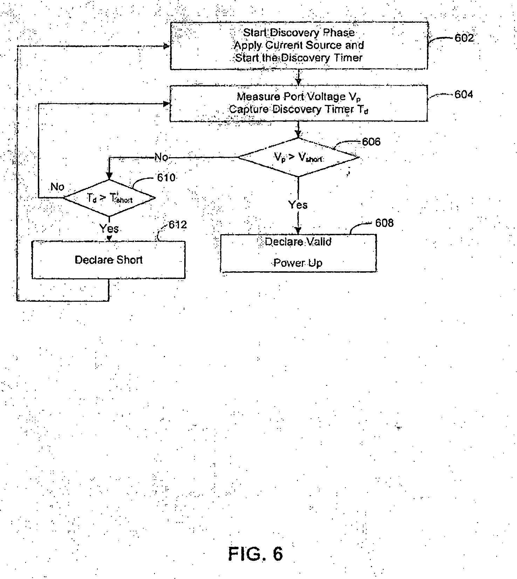

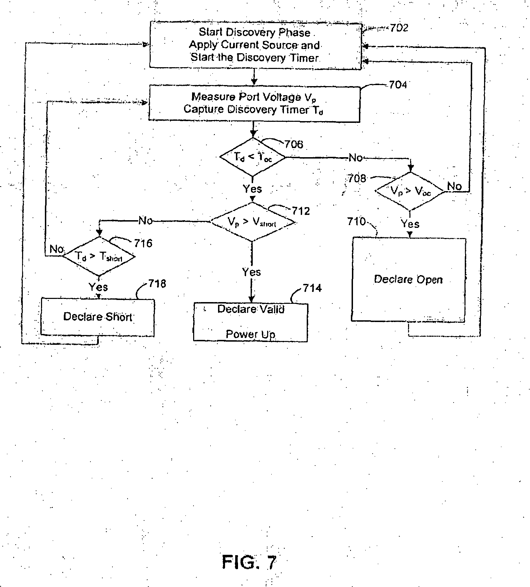

FIGS. 5-7 are flowcharts of methods 500 for reduced latency PoE discovery in accordance with an embodiment of the present disclosure. FIG. 5 illustrates a method for open circuit detection, FIG. 6 illustrates a method for short circuit detection, and FIG. 7 illustrates a method for combined open circuit and short circuit detection. In an embodiment, the methods of FIGS. 5-7 are performed by PSE controller 308. For example, in an embodiment, the methods of FIGS. 5-7 can be performed by control module 322 of PSE controller 308.

### 4.1 Open Circuit Detection

A method for open circuit detection in accordance with an embodiment of the present disclosure will now be described with reference to FIGS. 3, 4A, and 5. In step 502, PSE controller 306 starts a discovery timer T_{d} and applies current source 320 over wired communication link 304. In step 504, PSE controller 308 measures port voltage Vₚ 321 and captures the current value of T_{d}. In step 506, PSE controller 308 determines whether T_{d} is less than (or, in an embodiment, less than or equal to) T_{OC}, If T_{d} is not less than (or, in an embodiment, less than or equal to) T_{OC,} the method proceeds to step 504 because insufficient time has elapsed for PSE controller 308 to determine that an open circuit exists.

If, at step 506, PSE controller 308 determines that T_{d} is less than (or, in an embodiment, less than or equal to) T_{OC}, the method proceeds to step 508. In step 508, PSE controller 308 determines whether Vₚ is greater than (or, in an embodiment, greater than or equal to) V_{OC}. If PSE controller 308 determines that Vₚ is not greater than (or, in an embodiment, greater than or equal to) V_{OC}, the method proceeds to step 510 because PSE controller 308 determines that an open circuit exists, and the method optionally returns to step 502. If PSE controller 308 determines that Vₚ is greater than (or, in an embodiment, greater than or equal to) V_{OC}, the method proceeds to step 512 because PSE controller 308 determines that no open circuit exists. PSE controller 308 can then discover PD 314 and/or power up PD 314.

### 4.2 Short Circuit Detection

A method for short circuit detection in accordance with an embodiment of the present disclosure will now be described with reference to FIGS. 3, 4B, and 6. In step 602, the discovery phase is started. PSE controller 308 applies a current source and starts a discovery timer T_{d}. In step 604, PSE controller 308 obtains a measurement for port voltage Vₚ 321 and determines the current time of discovery timer T_{d}. In step 606, PSE controller 308 determines whether Vₚ 321 is greater than (or, in an embodiment, greater than or equal to) Vₛₕₒᵣₜ.

If Vₚ 321 is greater than (or, in an embodiment, greater than or equal to) Vₛₕₒᵣₜ, then the method proceeds to step 608, and PSE controller 308 determines that no short circuit exists. PD 314 can then be safely discovered and powered up. If PSE controller 308 determines that Vₚ 321 is not greater than (or, in an embodiment, greater than or equal to) Vₛₕₒᵣₜ, then the method proceeds to step 610. In step 610, if PSE controller 308 determines that T_{d} is not greater than (or, in an embodiment, greater than or equal to) Tₛₕₒᵣₜ (i.e., if insufficient time has elapsed for PSE controller 308 to determine that a short condition exists), the method returns to step 604. If PSE controller 308 determines that T_{d} is greater than (or, in an embodiment, greater than or equal to) Tₛₕₒᵣₜ, the method proceeds to step 612. In step 612, PSE controller 308 determines that a short circuit condition exists, and the method optionally returns to step 602.

### 4.3 Combined Short Circuit and Open Circuit Detection

A method for combined open circuit and short circuit detection in accordance with an embodiment of the present disclosure will now be described with reference to FIGS. 3, 4A, 4B, and 7. In step 702, the discovery phase is started. PSE controller 308 applies a current source and starts a discovery timer T_{d}. In step 704, PSE controller 308 obtains a measurement for the port voltage across wired communication link 304 and determines the current time of discovery timer T_{d}. In step 706, PSE controller 308 determines whether T_{d} is less than (or, in an embodiment, less than or equal to) T_{OC}.

If T_{d} is less than (or, in an embodiment, less than or equal to) T_{OC}, insufficient time has elapsed for PSE controller 308 to determine if an open circuit condition exists. Thus, PSE controller 308 does not check to see whether an open circuit condition exists but rather proceeds to check for short circuit conditions, and the method proceeds to step 712. In step 712, PSE controller 308 determines whether port voltage Vₚ 321 is greater than (or, in an embodiment, greater than or equal to) short circuit voltage threshold Vₛₕₒᵣₜ. If Vₚ 321 is greater than (or, in an embodiment, greater than or equal to) Vₛₕₒᵣₜ, then the method proceeds to step 714, and PSE controller 308 determines that PD 314 can be safely discovered and powered up. If PSE controller 308 determines that Vₚ 321 is not greater than (or, in an embodiment, greater than or equal to) Vₛₕₒᵣₜ, then the method proceeds to step 716.

In step 716, if PSE controller 308 determines that T_{d} is not greater than (or, in an embodiment, greater than or equal to) Tₛₕₒᵣₜ (i.e., if insufficient time has elapsed for PSE controller 308 to determine that a short condition exists), the method returns to step 704. If PSE controller 308 determines that T_{d} is greater than (or, in an embodiment, greater than or equal to) Tₛₕₒᵣₜ, the method proceeds to step 718. In step 718, PSE controller 308 determines that a short condition exists, and the method optionally returns to step 702.

Once T_{d} reaches T_{oc}, the method proceeds to begin checking for open circuit conditions instead of short circuit conditions. If, in step 706, T_{d} is not less than (or, in an embodiment, less than or equal to) T_{oc}, the method proceeds to step 708, and PSE controller 308 determines whether the port voltage Vₚ 321 is greater than (or, in an embodiment, greater than or equal to) open circuit voltage threshold V_{OC}. If Vₚ 321 is greater than (or, in an embodiment, greater than or equal to) V_{OC}, then PSE controller 228 determines that an open circuit condition has been detected, and the method then optionally returns to step 702. If Vₚ 321 is not greater than (or, in an embodiment, greater than or equal to) V_{OC}, then the method returns to step 702, and the timer T_{d} is reset so that the process can begin again until a determination is made regarding whether a short circuit or open circuit exists.

In an embodiment, to further reduce discovery latency, the method of FIG. 6 can be used instead of the method of FIG. 7. For example, the method of FIG. 6 avoids checking for open circuit conditions, which prevents the need to dissipate the port voltage Vₚ 321 between discovery states, which saves additional time.

### 5. Conclusion

It is to be appreciated that the Detailed Description, and not the Abstract, is intended to be used to interpret the claims. The Abstract may set forth one or more but not all exemplary embodiments of the present disclosure as contemplated by the inventor(s), and thus, is not intended to limit the present disclosure and the appended claims in any way.

The present disclosure has been described above with the aid of functional building blocks illustrating the implementation of specified functions and relationships thereof. The boundaries of these functional building blocks have been arbitrarily defined herein for the convenience of the description. Alternate boundaries can be defined so long as the specified functions and relationships thereof are appropriately performed.

The foregoing description of the specific embodiments will so fully reveal the general nature of the disclosure that others can, by applying knowledge within the skill of the art, readily modify and/or adapt for various applications such specific embodiments, without undue experimentation, without departing from the general concept of the present disclosure. Therefore, such adaptations and modifications are intended to be within the meaning and range of equivalents of the disclosed embodiments, based on the teaching and guidance presented herein. It is to be understood that the phraseology or terminology herein is for the purpose of description and not of limitation, such that the terminology or phraseology of the present specification is to be interpreted by the skilled artisan in light of the teachings and guidance.

The representative signal processing functions described herein can be implemented in hardware, software, or some combination thereof. For instance, the signal processing functions can be implemented using computer processors, computer logic, application specific circuits (ASIC), digital signal processors, etc., as will be understood by those skilled in the art based on the discussion given herein. Accordingly, any processor that performs the signal processing functions described herein is within the scope of the present disclosure.

The above systems and methods may be implemented as a computer program executing on a machine, as a computer program product, or as a tangible and/or non-transitory computer-readable medium having stored instructions. For example, the functions described herein could be embodied by computer program instructions that are executed by a computer processor or any one of the hardware devices listed above. The computer program instructions cause the processor to perform the signal processing functions described herein. The computer program instructions (e.g. software) can be stored in a tangible non-transitory computer usable medium, computer program medium, or any storage medium that can be accessed by a computer or processor. Such media include a memory device such as a RAM or ROM, or other type of computer storage medium such as a computer disk or CD ROM. Accordingly, any tangible non-transitory computer storage medium having computer program code that cause a processor to perform the signal processing functions described herein are within the scope of the present disclosure.

## Claims

1. A system (100), comprising:
a port; and
a power source equipment "PSE" controller (218, 308) coupled to the port, wherein the PSE controller (218, 308) is configured to:
determine (510, 512, 710) whether an open circuit (402) exists at the port;
determine (608, 612, 718) whether a short circuit (404) exists at the port; and the PSE controller is configured to:
determine (714) that the system (100) be safely powered up if no open circuit (402) or short circuit (404) exists at the port;
in order to determine whether the open circuit (402) exists **characterized in that** the PSE controller (218, 308) is further configured to:
apply a current to the port using a current source (320);
start a discovery time (T_{d}) while applying the current;
measure (504, 604, 704) a port voltage (Vₚ) at the port;
determine (508, 708) whether the port voltage (Vₚ) is greater than a predetermined open circuit voltage (V_{OC});
determine (506, 706) whether a discovery time (T_{d}) is greater than a predetermined open circuit time (T_{OC}); and
determine (510, 710) that the open circuit (402) exists if:
the discovery time (T_{d}) is greater than the predetermined open circuit time (T_{OC}), and
the port voltage (Vₚ) is greater than the predetermined open circuit voltage (V_{OC}).

2. The system (100) of claim 1, wherein the PSE controller (218, 308) is further configured to:
determine, using stored information, that a load (108) coupled to the port can be approximated as a resistor.

3. The system (100) of claim 1 or 2, further comprising:
a powered device "PD" (106) coupled to the port, wherein the PSE controller (218, 308) is further configured to initiate a power up of the PD (106) if no open circuit (402) or short circuit (404) exists at the port.

4. The system (100) of any preceding claim, wherein the PSE controller (218, 308) is further configured to:
measure (504, 604, 704) a port voltage (Vₚ) at the port;
determine (606, 712) whether the port voltage (Vₚ) is greater than a predetermined short circuit voltage (Vₛₕₒᵣₜ) ; and
determine (612) that the short circuit (404) exists if the port voltage (Vₚ) is less than the predetermined short circuit voltage (Vₛₕₒᵣₜ).

5. The system (100) of claim 4, wherein the PSE controller (218, 308) is further configured to:
determine (610, 716) whether a discovery time (T_{d}) is greater than a predetermined short circuit time (Tₛₕₒᵣₜ); and
determine (612, 718) that the short circuit (404) exists if:
the discovery time (T_{d}) is greater than the predetermined open circuit time (T_{oc}), and
the port voltage (Vₚ) is less than the predetermined short circuit voltage (Vₛₕₒᵣₜ).

6. A method for reduced latency discovery in a power over Ethernet (PoE) system (100), the method comprising:
determining (510, 710) whether an open circuit (402) exists at a port in the PoE system (100);
determining (612, 718) whether a short circuit (404) exists at the port;
determining (714) that the PoE system (100) can be safely powered up if no open circuit (402) or short circuit (404) exists at the port; wherein the step of determining whether the open circuit (402) exists is **characterized by** the steps of:
applying a current to the port; and
starting a discovery time (T_{d}) while applying the current;
measuring (504, 604, 704) a port voltage (Vₚ) at the port;
determining (506, 706) whether the discovery time (T_{d}) is greater than a predetermined open circuit time (T_{oc});
determining (508, 708) whether the port voltage (Vₚ) is greater than a predetermined open circuit voltage (V_{oc}); and
determining (510, 710) that the open circuit (402) exists if:
the discovery time (T_{d}) is greater than the predetermined open circuit time (T_{oc}), and
the port voltage (Vₚ) is greater than the predetermined open circuit voltage (V_{oc}).

7. The method of claim 6, further comprising
determining, using stored information, that a load (108) coupled to the port can be approximated as a resistor.

8. The method of claim 6 or 7, further comprising:
initiating a power up of a powered device "PD" (106) if no open circuit (402) or short circuit (404) exists at the port.

9. The method of any of claims 6 to 8, further comprising:
measuring (504, 604, 704) a port voltage (Vₚ) at the port;
determining (606, 712) whether the port voltage (Vₚ) is greater than a predetermined short circuit voltage (Vₛₕₒᵣₜ); and
determining (612, 718) that the short circuit (404) exists if the port voltage (Vₚ) is less than the predetermined short circuit voltage (Vₛₕₒᵣₜ).

## Patentansprüche

1. System (100) mit:
einem Port; und
einem Energieversorgungs (power source equipment "PSE") - Controller (218, 308), der an den Port gekoppelt ist, wobei der PSE-Controller (218, 308) konfiguriert ist zum:
Ermitteln (510, 512, 710), ob an dem Port ein offener Stromkreis (402) existiert;
Ermitteln (608, 612, 718), ob an dem Port ein Kurzschluss (404) existiert; und
wobei der PSE-Controller konfiguriert ist zum:
Ermitteln (714), dass das System (100) sicher hochgefahren werden kann, wenn an dem Port kein offener Stromkreis (402) oder Kurzschluss (404) existiert;
um zu ermitteln, ob der offene Stromkreis existiert - **dadurch gekennzeichnet, dass** der PSE-Controller (218, 308) des Weiteren konfiguriert ist zum:
Anlegen eines Stroms an den Port unter Verwendung einer Stromquelle (320);
Starten einer Ermittlungszeit (T_{d}) während des Anlegens des Stroms;
Messen (504, 604, 704) einer Port-Spannung (Vₚ) an dem Port;
Ermitteln (508, 708), ob die Port-Spannung (Vₚ) größer als eine vorgegebene Spannung des offenen Stromkreises (V_{oc}) ist;
Ermitteln (506, 706), ob eine Ermittlungszeit (T_{d}) größer als eine vorgegebene Zeit des offenen Stromkreises (T_{oc}) ist; und
Ermitteln (510, 710), dass der offene Stromkreis (402) existiert, wenn:
die Ermittlungszeit (T_{d}) größer als die Zeit des offenen Stromkreises (T_{oc}) ist, und
die Port-Spannung (Vₚ) größer als die vorgegebene Spannung des offenen Stromkreises (V_{oc}) ist.

2. System (100) nach Anspruch 1, wobei der PSE-Controller (218, 308) des Weiteren konfiguriert ist zum:
Ermitteln, unter Verwendung gespeicherter Informationen, dass eine Last (108), die an den Port gekoppelt ist, als Widerstand approximiert werden kann.

3. System (100) nach Anspruch 1 oder 2, das des Weiteren aufweist:
ein Verbrauchergerät (powered device "PD") (106), das an den Port gekoppelt ist, wobei der PSE-Controller (218, 308) des Weiteren dazu konfiguriert ist, das Hochfahren des Verbrauchergeräts (106) einzuleiten, wenn an dem Port kein offener Stromkreis (402) oder Kurzschluss (404) existiert.

4. System (100) nach einem der vorhergehenden Ansprüche, wobei der PSE-Controller (218, 308) des Weiteren konfiguriert ist zum:
Messen (504, 604, 704) einer Port-Spannung (Vₚ) an dem Port;
Ermitteln (606, 712), ob die Port-Spannung (Vₚ) größer als eine vorgegebene Kurzschlussspannung (Vₛₕₒᵣₜ) ist; und
Ermitteln (612), dass der Kurzschluss (404) existiert, wenn die Port-Spannung (Vₚ) kleiner als die vorgegebene Kurzschlussspannung (Vₛₕₒᵣₜ) ist.

5. System (100) nach Anspruch 4, wobei der PSE-Controller (218, 308) des Weiteren konfiguriert ist zum:
Ermitteln (610, 716), ob eine Ermittlungszeit (T_{d}) größer als eine vorgegebene Kurzschlusszeit (Tₛₕₒᵣₜ) ist; und
Ermitteln (612, 718), dass der Kurzschluss (404) existiert, wenn:
die Kurzschlusszeit (T_{d}) größer ist, als die vorgegebene Zeit des offenen Stromkreises (T_{oc}); und
die Port-Spannung (Vₚ) kleiner ist, als die vorgegebene Kurzschlussspannung (Vₛₕₒᵣₜ).

6. Verfahren zum Ermitteln reduzierter Latenz in einem Power over Ethernet (PoE) -System (100), wobei das Verfahren umfasst:
Ermitteln (510, 710), ob an einem Port in dem PoE-System (100) ein offener Stromkreis (402) existiert;
Ermitteln (612, 718), ob an dem Port ein Kurzschluss (404) existiert;
Ermitteln (714), dass das PoE-System (100) sicher hochgefahren werden kann, wenn an dem Port kein offener Stromkreis (402) oder Kurzschluss (404) existiert;
wobei der Schritt des Ermittelns, ob der offene Stromkreis (402) existiert, durch die folgenden Schritte gekennzeichnet ist:
Anlegen eines Stroms an den Port; und
Starten einer Ermittlungszeit (T_{d}) während des Anlegens des Stroms;
Messen (504, 604, 704) einer Port-Spannung (Vₚ) an dem Port;
Ermitteln (506, 706), ob die Ermittlungszeit (T_{d}) größer als eine vorgegebene Zeit des offenen Stromkreises (T_{oc}) ist;
Ermitteln (508, 708), ob die Port-Spannung (Vₚ) größer als eine vorgegebene Spannung des offenen Stromkreises (V_{oc}) ist; und
Ermitteln (510, 710), dass der offene Stromkreis (402) existiert, wenn:
die Ermittlungszeit (T_{d}) größer als die vorgegebene Zeit des offenen Stromkreises (T_{oc}) ist, und
die Port-Spannung (Vₚ) größer als die vorgegebene Spannung des offenen Stromkreises (V_{oc}) ist.

7. Verfahren nach Anspruch 6, das des Weiteren umfasst:
Ermitteln, unter Verwendung gespeicherter Informationen, dass eine Last (108), die an den Port gekoppelt ist, als Widerstand approximiert werden kann.

8. Verfahren nach Anspruch 6 oder 7, das des Weiteren umfasst:
Einleiten des Hochfahrens eines Verbrauchergeräts (powered device "PD") (106), wenn an dem Port kein offener Stromkreis (402) oder Kurzschluss (404) existiert.

9. Verfahren nach einem der Ansprüche 6 bis 8, das des Weiteren umfasst:
Messen (504, 604, 704) einer Port-Spannung (Vₚ) an dem Port;
Ermitteln (606, 712), ob die Port-Spannung (Vₚ) größer als eine vorgegebene Kurzschlussspannung (Vₛₕₒᵣₜ) ist; und
Ermitteln (612, 718), dass der Kurzschluss (404) existiert, wenn die Port-Spannung (Vₚ) kleiner als die vorgegebene Kurzschlussspannung (Vₛₕₒᵣₜ) ist.

## Revendications

1. Système (100), comprenant :
un port ; et
un contrôleur d'équipement de source d'alimentation électrique « PSE » (218, 308) couplé au port, dans lequel le contrôleur de PSE (218, 308) est configuré pour :
déterminer (510, 512, 710) si un circuit ouvert (402) existe au niveau du port ;
déterminer (608, 612, 718) si un court-circuit (404) existe au niveau du port ; et
le contrôleur de PSE est configuré pour :
déterminer (714) que le système (100) peut être en toute sécurité mis sous tension si aucun circuit ouvert (402) ou court-circuit (404) n'existe au niveau du port ;
afin de déterminer si le circuit ouvert (402) existe, **caractérisé en ce que** le contrôleur de PSE (218, 308) est en outre configuré pour :
appliquer un courant au port en utilisant une source (320) de courant ;
lancer un temps de découverte (T_{d}) tout en appliquant le courant ;
mesurer (504, 604, 704) une tension de port (Vₚ) au niveau du port ;
déterminer (508, 708) si la tension de port (Vₚ) est supérieure à une tension de circuit ouvert (V_{oc}) prédéterminée ;
déterminer (506, 706) si un temps de découverte (T_{d}) est supérieur à un temps de circuit ouvert (T_{oc}) prédéterminé ; et
déterminer (510, 710) que le circuit ouvert (402) existe si :
le temps de découverte (T_{d}) est supérieur au temps de circuit ouvert (T_{oc}) prédéterminé, et
la tension de port (Vₚ) est supérieure à la tension de circuit ouvert (V_{oc}) prédéterminée.

2. Système (100) selon la revendication 1, dans lequel le contrôleur de PSE (218, 308) est en outre configuré pour :
déterminer, en utilisant des informations stockées, qu'une charge (108) couplée au port peut être approchée comme une résistance.

3. Système (100) selon la revendication 1 ou 2, comprenant en outre :
un dispositif alimenté « PD » (106) couplé au port, dans lequel le contrôleur de PSE (218, 308) est en outre configuré pour initier une mise sous tension du PD (106) si aucun circuit ouvert (402) ou court-circuit (404) n'existe au niveau du port.

4. Système (100) selon une quelconque revendication précédente, dans lequel le contrôleur de PSE (218, 308) est en outre configuré pour :
mesurer (504, 604, 704) une tension de port (Vₚ) au niveau du port ;
déterminer (606, 712) si la tension de port (Vₚ) est supérieure à une tension de court-circuit (Vₛₕₒᵣₜ) prédéterminée ; et
déterminer (612) que le court-circuit (404) existe si la tension de port (Vₚ) est inférieure à la tension de court-circuit (Vₛₕₒᵣₜ) prédéterminée.

5. Système (100) selon la revendication 4, dans lequel le contrôleur de PSE (218, 308) est en outre configuré pour :
déterminer (610, 716) si un temps de découverte (T_{d}) est supérieur à un temps de court-circuit (Tₛₕₒᵣₜ) prédéterminé ; et
déterminer (612, 718) que le court-circuit (404) existe si :
le temps de découverte (T_{d}) est supérieur au temps de circuit ouvert (T_{oc}) prédéterminé, et
la tension de port (Vₚ) est inférieure à la tension de court-circuit (Vₛₕₒᵣₜ) prédéterminée.

6. Procédé pour une découverte de latence réduite dans un système (100) d'alimentation électrique sur Ethernet (PoE), le procédé comprenant :
la détermination (510, 710) si un circuit ouvert (402) existe au niveau d'un port dans le système (100) de PoE ;
la détermination (612, 718) si un court-circuit (404) existe au niveau du port ;
la détermination (714) que le système (100) de PoE peut être en toute sécurité mis sous tension si aucun circuit ouvert (402) ou court-circuit (404) n'existe au niveau du port ; dans lequel l'étape de détermination si le circuit ouvert (402) existe est **caractérisée par** les étapes de :
application d'un courant au port; et
lancement d'un temps de découverte (T_{d}) tout en appliquant le courant ;
mesure (504, 604, 704) d'une tension de port (Vₚ) au niveau du port ;
détermination (506, 706) si le temps de découverte (T_{d}) est supérieur à un temps de circuit ouvert (T_{oc}) prédéterminé ;
détermination (508, 708) si la tension de port (Vₚ) est supérieure à une tension de circuit ouvert (V_{oc}) prédéterminée ; et
détermination (510, 710) que le circuit ouvert (402) existe si :
le temps de découverte (T_{d}) est supérieur au temps de circuit ouvert (T_{oc}) prédéterminé, et
la tension de port (Vₚ) est supérieure à la tension de circuit ouvert (V_{oc}) prédéterminée.

7. Procédé selon la revendication 6, comprenant en outre la détermination, en utilisant des informations stockées, qu'une charge (108) couplée au port peut être approchée comme une résistance.

8. Procédé selon la revendication 6 ou 7, comprenant en outre :
l'initiation d'une mise sous tension d'un dispositif alimenté « PD » (106) si aucun circuit ouvert (402) ou court-circuit (404) n'existe au niveau du port.

9. Procédé selon l'une quelconque des revendications 6 à 8, comprenant en outre :
la mesure (504, 604, 704) d'une tension de port (Vₚ) au niveau du port ;
la détermination (606, 712) si la tension de port (Vₚ) est supérieure à une tension de court-circuit (Vₛₕₒᵣₜ) prédéterminée ; et
la détermination (612, 718) que le court-circuit (404) existe si la tension de port (Vₚ) est inférieure à la tension de court-circuit (Vₛₕₒᵣₜ) prédéterminée.
